# EUROPEAN PATENT SPECIFICATION

(11) **EP 3 030 050 B1**
(45) Date of publication and mention of the grant of the patent: **27.03.2019**
(21) Application number: 14196236.5
(22) Date of filing: 04.12.2014
(51) Int. Cl.: H05B 33/08, G05F 5/00, H03K 3/0233

(54) **Offset voltage eliminating circuit structure for protection mechanism of dimmer**
Offsetspannung beseitigende Schaltungsstruktur zum Schutz eines Dimmermechanismus
Structure de circuit d'élimination de tension de décalage pour mécanisme de protection de gradateur

(43) Date of publication of application: 08.06.2016
(73) Proprietor: Yu Jing Energy Technology Co., Ltd, New Taipei City 23941 (TW)
(72) Inventor: Yang, Sen-Tai, 23941 New Taipei City (TW)
(74) Representative: Roman, Alexis

(56) References cited:
- US-B1- 7 081 722

## Description

### 1. Field of the Invention

The invention relates to an offset voltage eliminating circuit structure for a protection mechanism of a dimmer, and more particularly, to a circuit that provides a current output when connected to an external resistive dimmer and eliminates the offset voltage created by an external limiting resistor used for circuit protection.

### 2. Description of the Prior Art

LEDs are widely used in various lighting conditions due to their characteristics such as low energy consumption and long life. However, there are considerable differences in the physical characteristics between LEDs and traditional light elements, such that a dimmer circuit suitable for a traditional light element may not be used directly to control the brightness of a LED. As such, one possible approach is to connect a converting circuit between the LED and the traditional dimmer circuit in order to turn the control mechanism of the traditional dimmer circuit into a control voltage for controlling the LED.

Traditional light dimmers can generally be classified as voltage, resistive and PWM types. Regardless of which type it is, an analog dimming signal from 0 to 10V is usually output. This voltage represents brightness from 0% to 100%. The above converting circuit must be able to accept the analog dimming signal (0 to 10V) output by the traditional dimmer and convert it into a control signal that is variable between 0% and 100% in order to drive an appended power supply to provide different voltages to the LED, thus allowing the LED to have different brightness.

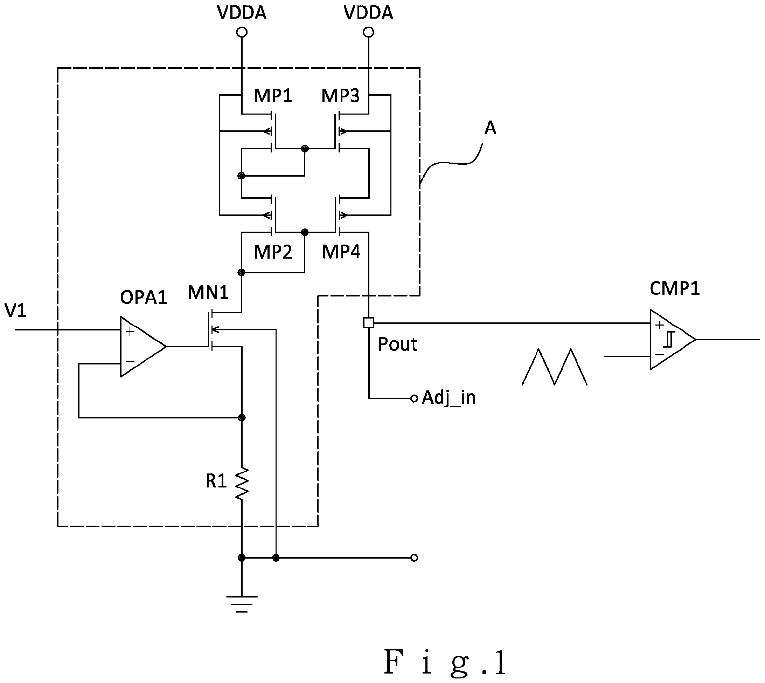

As shown in FIG. 1, a converting circuit that can be connected with a traditional dimmer is shown. The converting circuit mainly includes: a constant current source A and a hysteresis comparator CMP1, wherein the constant current source A is formed of a cascaded current mirror circuit consisting of symmetric P-type transistors MP1, MP2, MP3 and MP4 and an N-type transistor MN1, a first operational amplifier OPA1 and a first resistor R1. A voltage V1 can be input into the non-inverting input of the first operational amplifier OPA1. The inverting input of the first operational amplifier OPA1 is connected to the gate of the N-type transistor MN1 and grounded via the first resistor R1. The source of the P-type transistor MP4 is connected to an output Pout. The output Pout is also connected to a dimming signal input ADJ_in.

The non-inverting input of the hysteresis comparator CMP1 is connected to the output Pout (i.e. the dimming signal input ADJ_in), while the inverting input is input with a saw-tooth wave.

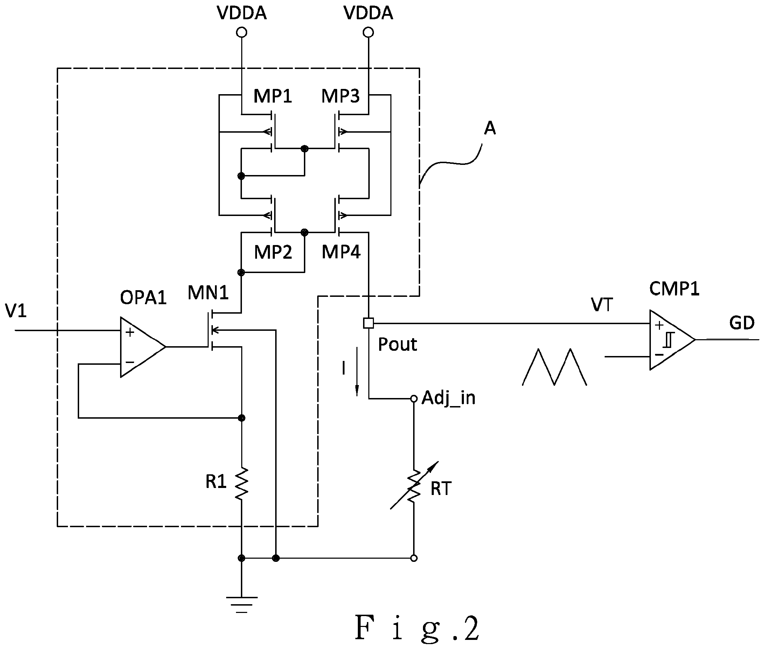

Referring to FIG. 2, when the above circuit is in actual use, if the dimming signal input ADJ_in is connected with an output of a traditional resistive dimmer (which can be regarded as a variable resistor RT), then the constant current source A is controlled to output a current I = V1/R1. The current flows through the variable resistor RT to create a voltage VT=RT*V1/R1. This voltage VT can be varied by adjusting the resistance of the variable resistor RT, and it can be input to the hysteresis comparator CMP1 through the output Pout. The hysteresis comparator CMP1 then compares it with the saw-tooth wave to output a GD pulse for adjusting the brightness of the LED. The amount of duty cycle of the GD pulse is proportional to VT.

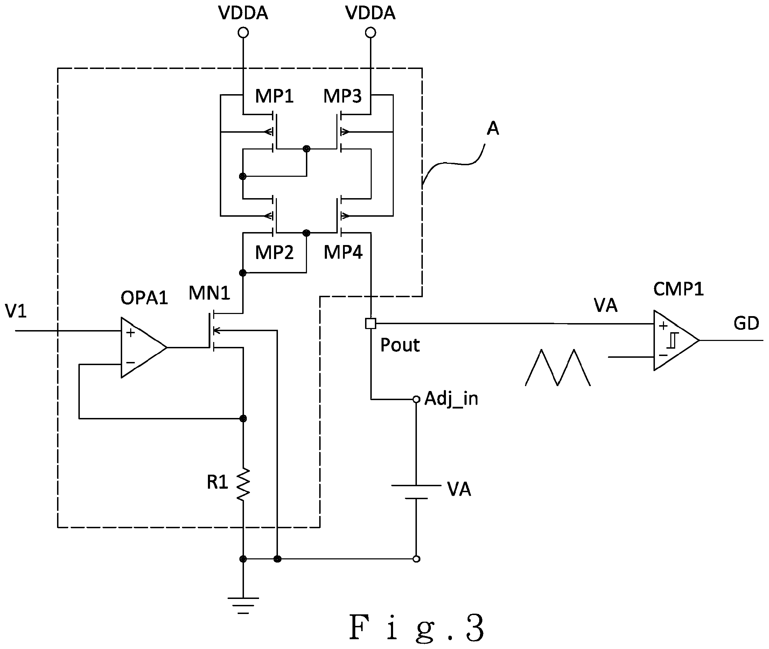

Referring now to FIG. 3, when the above circuit is in actual use, if the dimming signal input ADJ_in is connected with an output of a traditional voltage-type dimmer (which can be regarded as a DC voltage VA), then the DC voltage VA can be input into the hysteresis comparator CMP1 via the output Pout. The hysteresis comparator CMP1 then compares the DC voltage VA with the saw-tooth wave and outputs a GD pulse for adjusting the brightness of the LED.

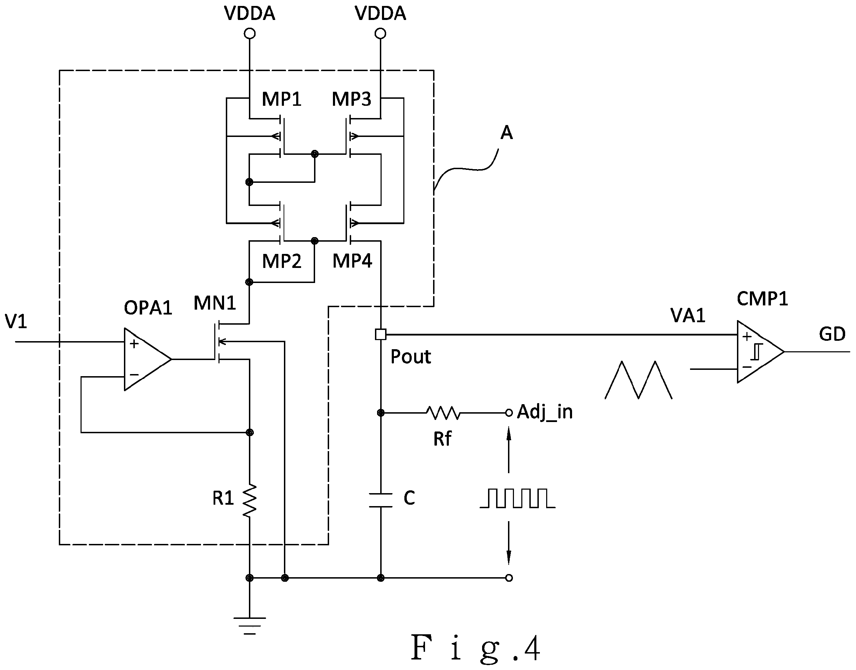

Referring now to FIG. 4, when the above circuit is in actual use, if the dimming signal input ADJ_in is connected with an output of a traditional PWM-type dimmer, then a resistor Rf can be provided between the dimming signal input ADJ_in and the output Pout, and the output Pout is further connected to ground via a capacitor C, thus forming a RC oscillating circuit using the resistor Rf and the capacitor C. The PWM signal creates an effective DC voltage VA1 on the output Pout through the discharging of the capacitor C. The voltage VA1 can be input into the hysteresis comparator CMP1 via the output Pout. The hysteresis comparator CMP1 then compares the DC voltage VA with the saw-tooth wave and outputs a GD pulse for adjusting the brightness of the LED.

However, in actual practice, a current-limiting resistor is provided on the dimming signal input ADJ_in to protect the constant current source A and associated circuits from damages caused by high voltage or reversed voltage polarities. Therefore, under normal use (this is especially the case for resistive dimmers, in which the control voltage is formed across a variable resistor RT by outputting a current from the constant current source A), any current that flows through the current-limiting resistor will inevitably create a voltage drop. When this voltage drop of the current-limiting resistor is added with the analog dimming signal input by the dimming signal input ADJ_in, it will cause a voltage offset on the analog dimming signal. This voltage offset will then affect the dimming control voltage output by the hysteresis comparator CMP1, so it must be eliminated in order to obtain the required analog dimming signal input.

In view of the shortcomings in the conventional converting circuit when in use, the present invention is proposed to provide improvements that address these shortcomings.

US 7 081 722 B1 discloses an offset voltage limiting circuit suitable for a protection mechanism of a dimmer according to the preamble of claim 1. The offset voltage eliminating circuit structure for a protection mechanism of a dimmer, comprises a constant current source including an output for outputting a stable current, the output connected with a dimming signal input through a current-limiting resistor, the dimming signal input connected with an output of an external dimmer; a subtractor formed by a third operational amplifier and second, third, fourth and fifth resistors, the second and the third resistors connected in series, and the non-inverting input of the third operational amplifier connected between the second and the third resistors the fourth and the fifth resistors connected in series, and the inverting input of the third operational amplifier connected between the fourth and the fifth resistors.

### SUMMARY OF THE INVENTION

One main objective of the present invention is to provide an offset voltage eliminating circuit structure for a protection mechanism of a dimmer, wherein a subtractor is provided for eliminating the voltage offset created by an additional current-limiting resistor used for circuit protection to obtain the correct dimming signal voltage.

Another objective of the present invention is to provide an offset voltage eliminating circuit structure for a protection mechanism of a dimmer, the main circuits of the structure can be packaged into a single integrated circuit, allowing more freedom and independence when being used, and reducing the overall size and improving space utilization.

This object is solved by the subject matter of claim 1.

The accomplishment of these and other objectives of the invention will become apparent from the following description and its accompanying drawings of which:

### BRIEF DESCRIPTION OF THE DRAWINGS

FIG. 1 is a circuit diagram illustrating a LED converting circuit that can be connected with a traditional dimmer.
FIG. 2 is a main circuit diagram illustrating the converting circuit of FIG. 1 connected with a traditional resistive dimmer.
FIG. 3 is a main circuit diagram illustrating the converting circuit of FIG. 1 connected with a traditional voltage-type dimmer.
FIG. 4 is a main circuit diagram illustrating the converting circuit of FIG. 1 connected with a traditional PWM-type dimmer.
FIG. 5 is a main circuit diagram of an offset voltage eliminating circuit in accordance with the present invention.
FIG. 6 is a main circuit diagram of the offset voltage eliminating circuit in accordance with the present invention connected with a traditional resistive dimmer.
FIG. 7 is a main circuit diagram of the offset voltage eliminating circuit in accordance with the present invention connected with a traditional voltage-type dimmer.
FIG. 8 is a main circuit diagram of the offset voltage eliminating circuit in accordance with the present invention connected with a traditional PWM-type dimmer.

### DETAILED DESCRIPTION OF THE PREFERRED EMBODIMENT

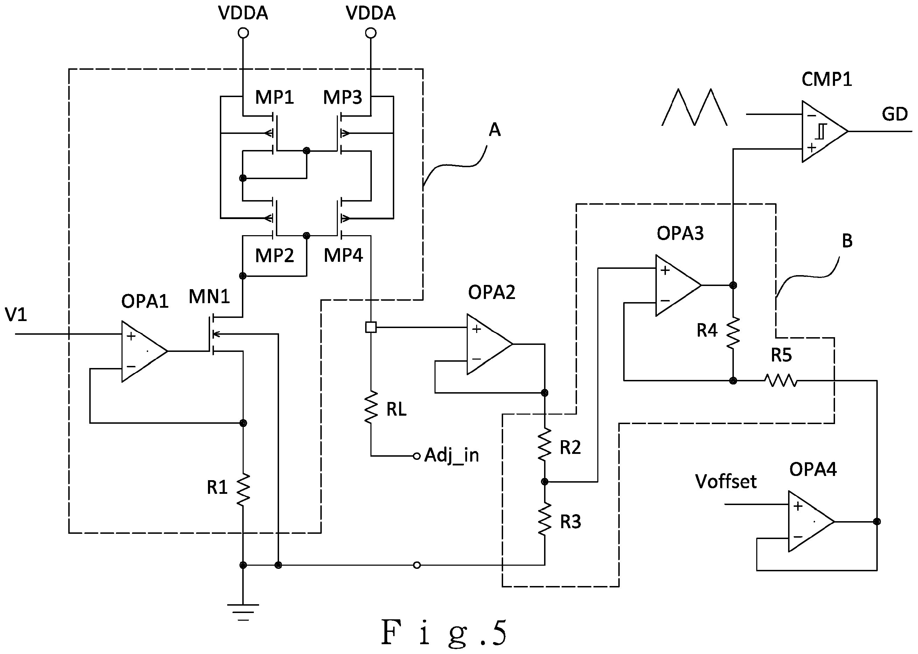

Referring to FIG. 5, a circuit structure in accordance with the present invention mainly includes: a constant current source A, a subtractor B and a hysteresis comparator CMP1. The constant current source A is formed of a cascaded current mirror circuit consisting of symmetric P-type transistors MP1, MP2, MP3 and MP4 and an N-type transistor MN1, a first operational amplifier OPA1 and a first resistor R1. A voltage V1 can be input into the non-inverting input of the first operational amplifier OPA1. The inverting input of the first operational amplifier OPA1 is connected to the gate of the N-type transistor MN1 and grounded via the first resistor R1. The source of the P-type transistor MP4 is connected to an output Pout. The output Pout is also connected to a dimming signal input ADJ_in.

The subtractor B is formed of a third operational amplifier OPA3 and second, third, fourth and fifth resistors R2, R3, R4 and R5 that have the same resistances. The second and the third resistors R2 and R3 are connected in series, and the non-inverting input of the third operational amplifier OPA3 is connected between the second and the third resistors R2 and R3. The other end of the second resistor R2 is connected with the output Pout, and the other end of the third resistor R3 is connected to ground. The fourth and the fifth resistors R4 and R5 are connected in series, and the inverting input of the third operational amplifier OPA3 is connected between the fourth and the fifth resistors R4 and R5. The other end of the fourth resistor R4 is connected between the output and the inverting input of the third operational amplifier OPA3, and the other end of the fifth resistor R5 is input with an offset reference voltage Voffset.

In one implementation, one end of the fifth resistor R5 away from the fourth resistor R4 can be connected to a fourth operational amplifier OPA4 depending on the needs. The non-inverting input of the fourth operational amplifier OPA4 is input with the offset reference voltage Voffset, and the output and the inverting input of the fourth operational amplifier OPA4 are both connected to the fifth resistor R5. Furthermore, a second operational amplifier OPA2 is provided between the output Pout of the constant current source A and the second resistor R2 of the subtractor B. The non-inverting input of the second operational amplifier OPA2 is connected with the output Pout of the constant current source A, and the inverting input of the second operational amplifier OPA2 is connected with both the output of the second operational amplifier OPA2 and the second resistor R2.

The hysteresis comparator CMP1 has a non-inverting input and an inverting input. The non-inverting input is connected to the output of the third operational amplifier OPA3, while the inverting input is input with a saw-tooth wave. The hysteresis comparator CMP1 also has an output.

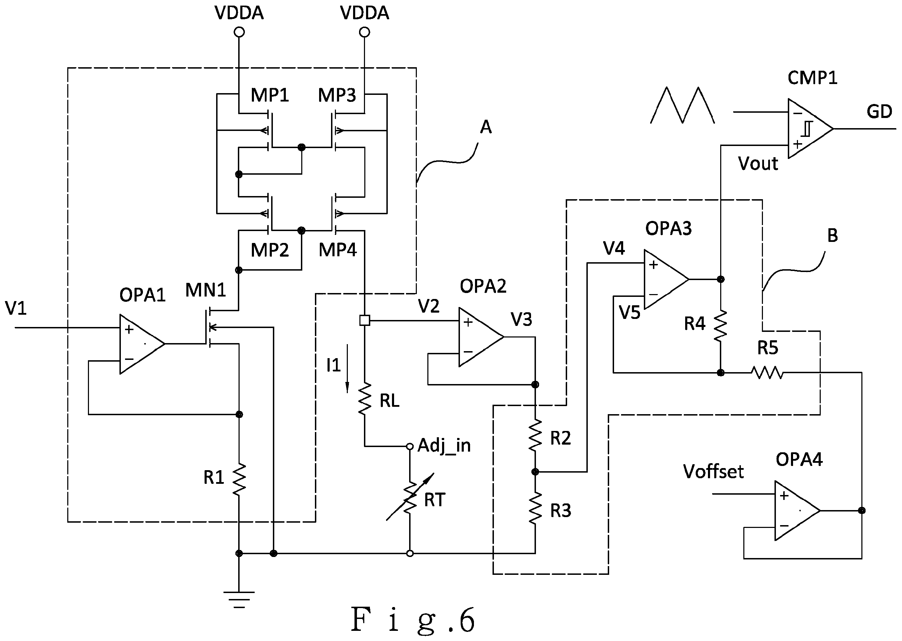

Referring to FIG. 6, when the embodiment of the present invention is connected with a traditional resistive dimmer, the dimming signal input ADJ_in can be regarded as connected with a variable resistor RT, then the constant current source A is controlled to output a constant current 11 (the current 11 is constant and not adjustable, but can be set through the resistor R1). When the current 11 flows through the current-limiting resistor RL and the variable resistor RT, a voltage is created across the current-limiting resistor (VL=I1*RL), and a voltage is created across the variable resistor (VT1=I1*RT) (the voltage VT1 can be changed by adjusting the variable resistor RT). Thus, the voltage at the output Pout is V2=VL+VT1, wherein the dimming signal voltage actually required is the voltage of the variable resistor VT1, whereas the voltage of the current-limiting resistor is an offset voltage.

Assuming the voltage V2 is input into the buffering second operational amplifier OPA2, and from which a voltage V3 is output (V2=V3); the fourth operational amplifier OPA4 outputs the offset reference voltage Voffset; and the inverting and non-inverting inputs of the third operational amplifier OPA3 in the subtractor B are input with a voltage V5 and a voltage V4, respectively, and the output of the third operational amplifier OPA3 has an output voltage Vout, then Vout=[(1+R4/R5)*V4]-(R4/R5)*Voffset=2V4-Voffset, and V4=[R3/(R2+R3)]*V3=0.5*V3, so Vout=V3-Voffset. Furthermore, V2=V3=VL+VT1, so Vout=VL+VT1-Voffset. If Voffset=VL, then Vout=VT1.

Therefore, if the non-inverting input of the fourth operational amplifier OPA4 is input with an offset reference voltage Voffset that is equal to the voltage of the current-limiting resistor VL (i.e. I1*RL) in magnitude, then the offset voltage can be eliminated (since the current I1 and the current-limiting resistor RL are known, obtaining the value of the voltage of the current-limiting resistor VL is straightforward), such that the final output voltage Vout will be equal to the dimming signal voltage VT1 input by the dimming signal input ADJ_in. Thereafter, the output voltage Vout can be input the hysteresis comparator CMP1. The hysteresis comparator CMP1 compares the output voltage Vout with the saw-tooth wave to output a GD pulse for adjusting the brightness of the LED. The amount of duty cycle of the GD pulse is proportional to VT.

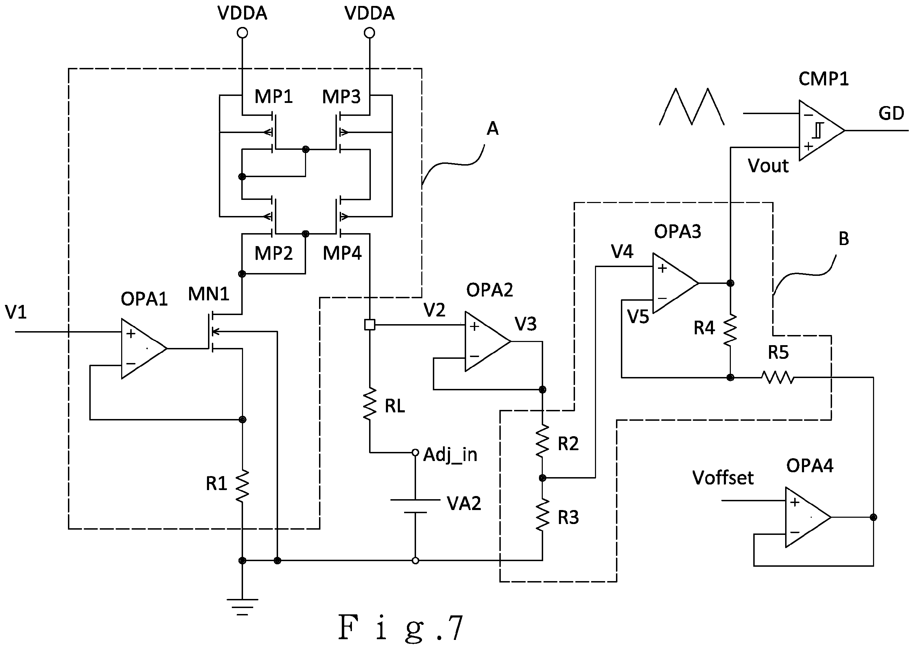

Referring to FIG. 7, when the embodiment of the present invention is connected with a traditional voltage-type dimmer, the dimming signal input ADJ_in can be regarded as connected with a DC voltage VA2. When the circuit is conducting, a current flows through the current-limiting resistor RL to create a voltage across the current-limiting resistor VL1. This voltage VL1 is the offset voltage.

Similarly, if the non-inverting input of the fourth operational amplifier OPA4 is input with an offset reference voltage Voffset that is equal to the voltage of the current-limiting resistor VL1 in magnitude, then the offset voltage (that is, the voltage of the current-limiting resistor VL1) can be eliminated, such that the final output voltage Vout will be equal to the dimming signal voltage VA2 input by the dimming signal input ADJ in. Thereafter, the output voltage Vout can be input the hysteresis comparator CMP1. The hysteresis comparator CMP1 compares the output voltage Vout with the saw-tooth wave to output a GD pulse for adjusting the brightness of the LED.

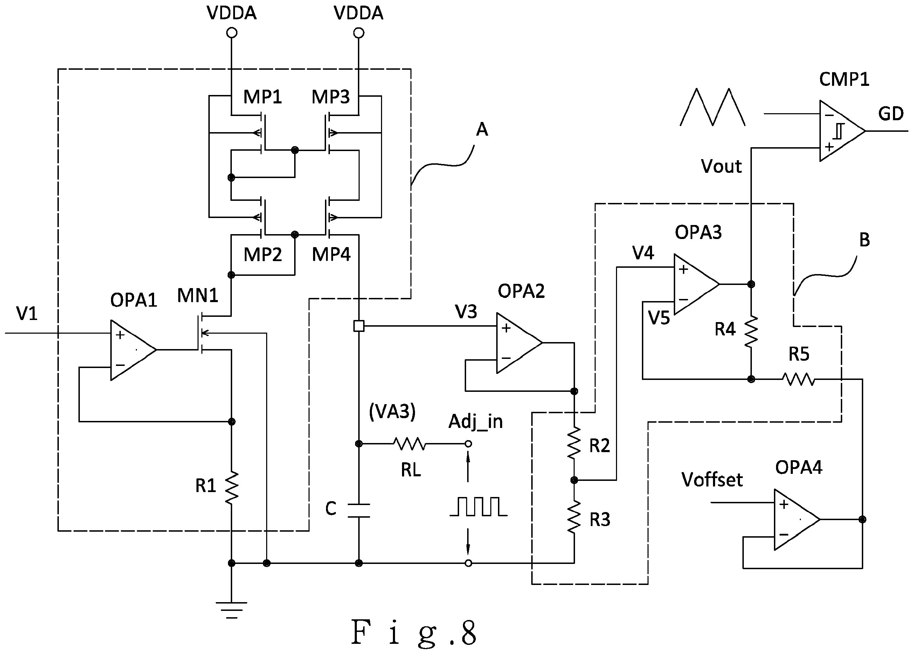

Referring to FIG. 8, when the embodiment of the present invention is connected with a traditional PWM-type dimmer, the output Pout is grounded through a capacitor C. The current-limiting resistor RL and the capacitor C form a RC oscillating circuit, such that the PWM signal creates an effective DC voltage VA3 on the output Pout through the discharging of the capacitor C. When the circuit is conducting, a current flows through the current-limiting resistor RL to create a voltage across the current-limiting resistor VL3. This voltage VL3 is the offset voltage.

Similarly, if the non-inverting input of the fourth operational amplifier OPA4 is input with an offset reference voltage Voffset that is equal to the voltage of the current-limiting resistor VL1 in magnitude, then the offset voltage (that is, the voltage of the current-limiting resistor VL3) can be eliminated, such that the final output voltage Vout will be equal to the dimming signal voltage VA3 input by the dimming signal input ADJ_in. Thereafter, the output voltage Vout can be input the hysteresis comparator CMP1. The hysteresis comparator CMP1 compares the output voltage Vout with the saw-tooth wave to output a GD pulse for adjusting the brightness of the LED.

In view of the above, the offset voltage eliminating circuit structure for a protection mechanism of a dimmer in accordance with the present invention achieves the effect of effectively removing the voltage difference (offset) created by an external current-limiting resistor, and is thus submitted to be novel and non-obvious. A patent application is hereby filed in accordance with the patent law. It should be noted that the descriptions given above are merely descriptions of preferred embodiments of the present invention, various changes, modifications, variations or equivalents can be made to the invention.

## Claims

1. An offset voltage eliminating circuit structure for a protection mechanism of a dimmer, comprising:
a constant current source (A) including an output (Pout) for outputting a stable current, the output (Pout) connected with a dimming signal input (ADJ_in) through a current-limiting resistor (RL), the dimming signal input (ADJ_in) connected with an output of an external dimmer;
a subtractor (B) formed by a third operational amplifier (OPA3) and second, third, fourth and fifth resistors (R2, R3, R4, R5), the second and the third resistors (R2, R3) connected in series, and the non-inverting input of the third operational amplifier (OPA3) connected between the second and the third resistors (R2,R3), , the fourth and the fifth resistors (R4, R5) connected in series, and the inverting input of the third operational amplifier (OPA3) connected between the fourth and the fifth resistors (R4, R5),
**characterized in that**
the second, third, fourth and fifth resistors (R2, R3, R4, R5) have the same resistances; and
the other end of the second resistor (R2) is connected with the output (Pout), and the other end of the third resistor (R3) is connected to ground; and
the other end of the fourth resistor (R4) is connected between the
output of the third operational amplifier (OPA3) and the inverting input of the third operational amplifier (OPA3), and the other end of the fifth resistor (R5) being input with an offset reference voltage (Voffset); and the offset voltage eliminating circuit structure for the protection mechanism of the dimmer further comprising
a hysteresis comparator (CMP1) including a non-inverting input, an inverting input and an output capable of outputting a GD pulse signal, the non-inverting input connected to the output of the third operational amplifier (OPA3), and the inverting input being input with a saw-tooth wave.

2. The offset voltage eliminating circuit structure as claimed in claim 1, wherein the constant current source (A) is formed of two symmetric sets of P-type transistors (MP1, MP2, MP3, MP4) with two transistors connected in series in each set, wherein one set of the P-type transistors is further connected with an N-type transistor (MN1) to form a cascaded current mirror circuit, and the N-type transistor (MN1) is further connected with an operational amplifier (OPA1) and a resistor (Rl), the non-inverting input of the operational amplifier (OPA1) is grounded through the resistor (R1), and the other set of P-type transistors is connected to an output (Pout).

3. The offset voltage eliminating circuit structure as claimed in claim 1, wherein one end of the fifth resistor (R5) away from the fourth resistor (R4) is connected to a fourth operational amplifier (OPA4), the non-inverting input of the fourth operational amplifier (OPA4) is input with the offset reference voltage (Voffset), and the output and the inverting input of the fourth operational amplifier (OPA4) are both connected to the fifth resistor (R5).

4. The offset voltage eliminating circuit structure as claimed in claim 1, wherein a second operational amplifier (OPA2) is provided between the output (Pout) of the constant current source (A) and the second resistor (R2) of the subtractor (B), the non-inverting input of the second operational amplifier (OPA2) is connected with the output (Pout) of the constant current source (A), and the inverting input of the second operational amplifier (OPA2) is connected with both the output of the second operational amplifier (OPA2) and the second resistor (R2).

## Patentansprüche

1. Offsetspannung beseitigende Schaltungsstruktur für einen Schutzmechanismus eines Dimmers, umfassend:
eine Konstantstromquelle (A), die einen Ausgang (Pout) zum Ausgeben eines stabilen Stroms einschließt, wobei der Ausgang (Pout) über einen Strombegrenzungswiderstand (RL) an einen Dimmsignaleingang (ADJ_in) angeschlossen ist, wobei der Dimmsignaleingang (ADJ_in) an einen Ausgang eines externen Dimmers angeschlossen ist;
einen Subtrahierer (B), der von einem dritten Operationsverstärker (OPA3) und zweiten, dritten, vierten und fünften Widerständen (R2, R3, R4, R5) gebildet wird, wobei der zweite und der dritte Widerstand (R2, R3) in Reihe geschaltet sind, und der nicht invertierende Eingang des dritten Operationsverstärkers (OPA3) zwischen dem zweiten und dem dritten Widerstand (R2, R3) angeschlossen ist, wobei der vierte und der fünfte Widerstand (R4, R5) in Reihe geschaltet sind, und der invertierende Eingang des dritten Operationsverstärkers (OPA3) zwischen dem vierten und dem fünften Widerstand (R4, R5) angeschlossen ist,
**dadurch gekennzeichnet, dass**
der zweite, dritte, vierte und fünfte Widerstand (R2, R3, R4, R5) dieselben Widerstände aufweisen; und
das endere Ende des zweiten widerstands (R2) an den Ausgang (Pout) angeschlossen ist, und das andere Ende des dritten Widerstands (R3) an Masse angeschlossen ist; und
das andere Ende des vierten Widerstands (R4) zwischen dem Ausgang des dritten Operationsverstärkers (OPA3) und dem invertierenden Eingang des dritten Operationsverstärkers (OPA3) angeschlossen ist, und wobei das andere Ende des fünften Widerstands (R5) mit einer Offset-Referenzspannung (Voffset) eingegeben wird; und wobei die Offsetspannung beseitigende Schaltungsstruktur für den Schutzmechanismus des Dimmers weiter umfasst einen Hysteresekomparator (CMP1), der einen nicht invertierenden Eingang, einen invertierenden Eingang und einen Ausgang einschließt, welcher in der Lage ist, ein GD-Impulssignal auszugeben, wobei der nicht invertierende Eingang an den Ausgang des dritten Operationsverstärkers (OPA3) angeschlossen ist, und der invertierende Eingang mit einer Sägezahnwelle eingegeben wird.

2. Offsetspannung beseitigende Schaltungsstruktur nach Anspruch 1, wobei die Konstantstromquelle (A) von zwei symmetrischen Sätzen P-Typ-Transistoren (MP1, MP2, MP3, MP4) mit in jedem Satz zwei in Reihe geschalteten Transistoren gebildet wird, wobei ein Satz der P-Typ-Transistoren weiter an einen N-Typ-Transistor (MN1) angeschlossen ist, um eine kaskadierte Stromspiegelschaltung zu bilden, und der N-Typ-Transistor (MN1) weiter an einen Operationsverstärker (OPA1) und einen Widerstand (R1) angeschlossen ist, der nicht invertierende Eingang des Operationsverstärkers (OPA1) über den Widerstand (R1) geerdet ist, und der andere Satz P-Typ-Transistoren an einen Ausgang (Pout) angeschlossen ist.

3. Offsetspannung beseitigende Schaltungsstruktur nach Anspruch 1, wobei ein Ende des fünften Widerstands (R5) vom vierten Widerstand (R4) weg an einen vierten Operationsverstärker (OPA4) angeschlossen ist, der nicht invertierende Eingang des vierten Operationsverstärkers (OPA4) mit der Offset-Referenzspannung (Voffset) eingegeben wird, und sowohl der Ausgang als auch der invertierende Eingang des vierten Operationsverstärkers (OPA4) an den fünften Widerstand (R5) angeschlossen sind.

4. Offsetspannung beseitigende Schaltungsstruktur nach Anspruch 1, wobei ein zweiter Operationsverstärker (OPA2) zwischen dem Ausgang (Pout) der Konstantstromquelle (A) und dem zweiten Widerstand (R2) des Subtrahierers (B) bereitgestellt ist, der nicht invertierende Eingang des zweiten Operationsverstärkers (OPA2) an den Ausgang (Pout) der Konstantstromquelle (A) angeschlossen ist, und der invertierende Eingang des zweiten Operationsverstärkers (OPA2) an sowohl den Ausgang des zweiten Operationsverstärkers (OPA2) als auch den zweiten Widerstand (R2) angeschlossen ist.

## Revendications

1. Structure de circuit d'élimination de tension de décalage pour un mécanisme de protection d'un gradateur, comprenant :
une source de courant constant (A) comprenant une sortie (Pout) pour la sortie d'un courant stable, la sortie (Pout) étant reliée à une entrée de signal de gradation (ADJ_in) via une résistance de limitation de courant (RL), l'entrée de signal de gradation (ADJ_in) étant reliée à une sortie d'un gradateur externe ;
un soustracteur (B) formé par un troisième amplificateur fonctionnel (OPA3) et des deuxième, troisième, quatrième et cinquième résistances (R2, R3, R4, R5), les deuxième et troisième résistances (R2, R3) étant reliées en série, et l'entrée non inversée du troisième amplificateur fonctionnel (OPA3) étant reliée entre les deuxième et troisième résistances (R2, R3), les quatrième et cinquième résistances (R4, R5) étant reliées en série, et l'entrée inversée du troisième amplificateur fonctionnel (OPA3) étant reliée entre les quatrième et cinquième résistances (R4, R5),
**caractérisée en ce que**
les deuxième, troisième, quatrième et cinquième résistances (R2, R3, R4, R5) ont les mêmes résistances ; et
l'autre extrémité de la deuxième résistance (R2) est reliée à la sortie (Pout), et l'autre extrémité de la troisième résistance (R3) est reliée à la terre ; et
l'autre extrémité de la quatrième résistance (R4) est reliée entre la sortie du troisième amplificateur fonctionnel (OPA3) et l'entrée inversée du troisième amplificateur fonctionnel (OPA3), et l'autre extrémité de la cinquième résistance (R5) étant entrée avec une tension de référence de décalage (Voffset) ; et la structure de circuit d'élimination de tension de décalage pour le mécanisme de protection du gradateur comprenant en outre
un comparateur d'hystérèse (CMP1) comprenant une entrée non inversée, une entrée inversée et une sortie capable d'émettre un signal d'impulsion GD, l'entrée non inversée étant reliée à la sortie du troisième amplificateur fonctionnel (OPA3), et l'entrée inversée étant entrée avec une onde en dents de scie.

2. Structure de circuit d'élimination de tension de décalage selon la revendication 1, dans laquelle la source de courant constant (A) est formée de deux ensembles symétriques de transistors de type P (MP1, MP2, MP3, MP4) avec deux transistors reliés en série dans chaque ensemble, dans laquelle un ensemble de transistors de type P est relié en outre à un transistor de type N (MN1) pour former un circuit de miroir de courant en cascade, le transistor de type N (MN1) est relié en outre à un amplificateur fonctionnel (OPA1) et à une résistance (R1), l'entrée non inversée de l'amplificateur fonctionnel (OPA1) est mise à la terre par la résistance (R1), et l'autre ensemble de transistors de type P est relié à une sortie (Pout).

3. Structure de circuit d'élimination de tension de décalage selon la revendication 1, dans laquelle une extrémité de la cinquième résistance (R5) éloignée de la quatrième résistance (R4) est reliée à un quatrième amplificateur fonctionnel (OPA4), l'entrée non inversée du quatrième amplificateur fonctionnel (OPA4) est entrée avec la tension de référence de décalage (Voffset), et la sortie et l'entrée inversée du quatrième amplificateur fonctionnel (OPA4) sont toutes deux reliées à la cinquième résistance (R5).

4. Structure de circuit d'élimination de tension de décalage selon la revendication 1, dans laquelle un deuxième amplificateur fonctionnel (OPA2) est prévu entre la sortie (Pout) de la source de courant constant (A) et la deuxième résistance (R2) du soustracteur (B), l'entrée non inversée du deuxième amplificateur fonctionnel (OPA2) est reliée à la sortie (Pout) de la source de courant constante (A), et l'entrée inversée du deuxième amplificateur fonctionnel (OPA2) est reliée à la fois à la sortie du deuxième amplificateur fonctionnel (OPA2) et à la deuxième résistance (R2).
